# EUROPEAN PATENT APPLICATION

(11) **EP 2 924 814 A1**
(43) Date of publication of application: **30.09.2015**
(21) Application number: 15159687.1
(22) Date of filing: 18.03.2015
(51) Int. Cl.: H01R 13/66, H01R 43/16, H01R 43/24

(54) **CIRCUIT MOUNTING APPARATUS AND METHOD USING A SEGMENTED LEAD-FRAME**

(30) Priority: 18.03.2014 US 201414217874
(71) Applicant: TRW Automotive U.S. LLC, Livonia, Michigan 48150 (US)
(72) Inventor: Murray, Neil G., Jr., Wixom, MI Michigan 48393 (US); Ramsay, Mark, Livonia, MI Michigan 48152 (US)
(74) Representative: Emde, Eric

(57) **Abstract**

A circuit mounting assembly having a segmented lead frame, and an integrated circuit mounted on the segmented lead frame. The segmented lead frame has a main body portion with at least one severable slot and a plurality of connectors extending from the main body portion. Electrical communication between the plurality of connectors and the integrated circuit is controlled by severance of the at least one slot.

## Description

### Field of the Invention

The present invention is directed to a circuit mounting apparatus and method and is more particularly direct to a circuit mounting apparatus and method that uses a segmented lead-frame.

### Background of the Invention

Electrical circuit components have for years been mounted onto a printed circuit board ("PCB"). The PCB is then typically mounted into a housing structure and the housing structure is then, in turn, mounted into a use device such as a mounting structure in a vehicle. The electrical circuitry on the PCB could include discrete circuit components as well as integrated circuits. Electrical circuits that have a specific use could be assembled in application specific integrated circuit ("ASIC"). ASIC's are often used in vehicle applications such as sensing circuits that are part of an actuatable occupant restraining system in a vehicle. Such ASIC's in actuatable occupant restraining systems may include one or more vehicle crash sensors for sensing the occurrence of a vehicle crash condition. The sensor ASIC is mounted to a PCB and the PCB is, in turn, mounted in a protective housing. The housing is then mounted in the vehicle. The housing has an electrical connector that permits electrical communications between the ASIC on the PCB with external controls such as an electronic control unit ("ECU") of the actuatable occupant restraining system. When a vehicle crash condition is detected, the ECU actuates an actuatable restraining device, such as an air bag.

Known circuit mounting arrangements that use PCB's require that the circuit components be soldered to the PCB. Metal connection terminals are also attached to the PCB and electrically connected to the circuitry on the PCB. The PCB and connectors are then mounted into a housing. One proposed sensor assembly that protects the sensor from the harsh environmental conditions is disclosed in copending patent application entitled METHOD AND APPARATUS FOR PACKAGING CRASH SENSORS to Campbell et al., U.S. Ser. No. 13/002,696 which is assigned to the assignee of the present application and which is hereby fully incorporated herein by reference.

### Summary of the Invention

In accordance with one embodiment of the present invention, a circuit mounting assembly is provided having a segmented lead frame, and an integrated circuit mounted on the segmented lead frame. The segmented lead frame has a main body portion with at least one severable slot and a plurality of connectors extending from the main body portion. Electrical communication between the plurality of connectors and the integrated circuit is controlled by severance of the at least one slot.

In accordance with another example embodiment of the present invention, a method is provided for assembling a circuit comprising the steps of mounting an integrated circuit to a segmented lead frame having at least one severable slot and a plurality of connectors, securing the integrated circuit to the segmented lead frame; and severing the at least one severable slot so as to provide a desired electrical connection between the connectors and the integrated circuit.

### Brief Description of the Drawings

The foregoing and other features and advantages of the present invention will become apparent to those skilled in the art to which the present invention relates upon reading the following description with reference to the accompanying drawings, in which:
Fig. 1 is a perspective view of a segmented lead-frame made in accordance with one example embodiment of the present invention;
Fig. 2 is a top view of a circuit assembly having the segmented lead-frame of Fig. 1 with an application specific integrated circuit secured thereto;
Fig. 3 is a perspective view of the circuit assembly of Fig. 2 with a first overmolded plastic layer in accordance with one example embodiment of the present invention;
Fig. 4 is a perspective view of a housing that would house the circuit assembly shown in Fig. 3;
Fig. 5 is a cut away view of a portion of the housing of Fig. 4 showing the circuit assembly of Fig. 3 mounted therein;
Fig. 6 is a top plane view of the segmented lead-frame made in accordance with another example embodiment of the present invention; and
Fig. 7 is a perspective view of a circuit assembly having the segmented lead-frame of Fig. 6 with an application specific integrated circuit secured thereto.

### Detailed Description

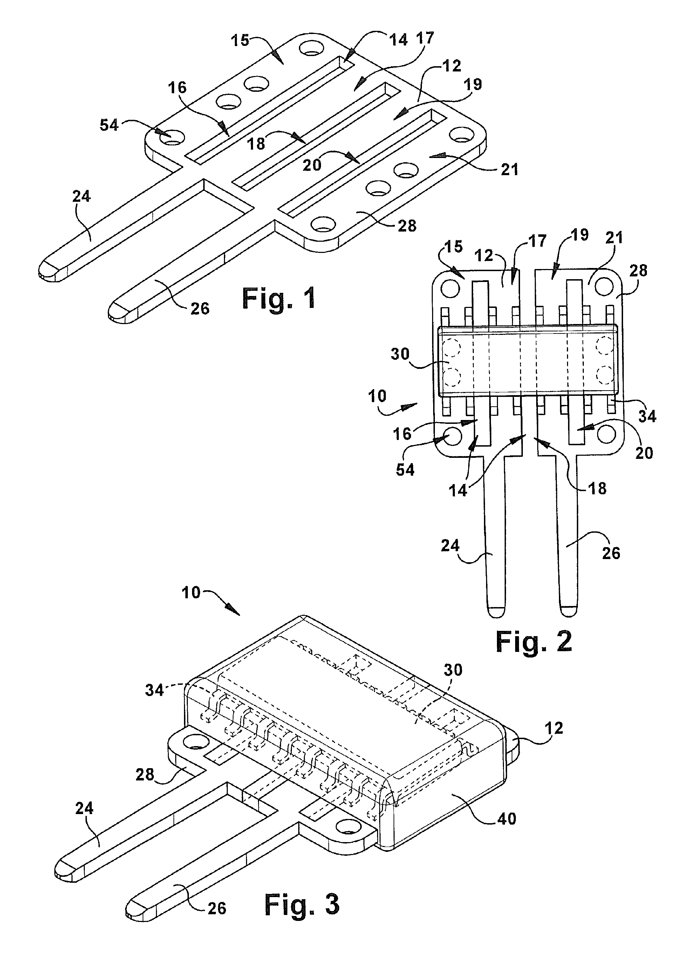

Referring to Figs. 1-3, a lead-frame assembly 10, made in accordance with one example embodiment of the present invention, is shown. The lead-frame assembly 10 includes a slotted lead-frame 12 having a plurality of slots 14. In accordance with one example embodiment of the present invention, the lead-frame 12 includes three slots 16, 18, 20.

The lead-frame 12 is a metallic substrate formed as a coupon through stamping or some other forming process. For example, the stamping could include a plurality of lead-frame coupons 12 formed in a single stamping process where the individual lead-frame coupons are subsequently separated into individual lead-frames.

The slots 16, 18, 20 separate a main body portion 28 of the lead-frame 12 into four segmented areas 15, 17, 19, 21. Since the slots 16, 18, 20 are not cut all the way through to the ends of main body portion 28, areas 15, 17, 19, and 21 are electrically connected together. Those skilled in the art will appreciate that cutting through of a selected slot, 18 for example, will electrically isolate the areas 15, 17 from the areas 19, 21.

The lead-frame 12 further includes a plurality of electrical connectors 24, 26 that extend outward from the main body portion 28 of the lead-frame 12. The electrical connectors 24, 26 are used to provide an electrical connection to any circuit element mounted to the main body portion 28 of the lead-frame 12.

An application specific integrated circuit ("ASIC") 30 is attached to the slotted lead-frame 12 such as, for example, by soldering. The ASIC 30 could, for example, include internal crash sensors such as an accelerometer and a pressure sensor if the circuit assembly is a crash sensor device. The ASIC 30 could also include associated processing circuitry. The electrical connectors 24, 26 are connectable to an electrical bus of the vehicle so as to provide electrical communications between the ASIC 30 and control circuitry of the vehicle such as an electronic control unit ("ECU") of the actuatable restraining system. To attach the ASIC 30 to the lead-frame 12 and to provide electrical connections between the circuit elements within the ASIC, the ASIC 30 includes a plurality of electrical leads 34 that are welded or soldered to the lead-frame 12. The electrical leads 34 provide both a mechanical and electrical connection of the ASIC 30 to the main body portion 28 of the lead-frame 12.

Once the ASIC 30 is secured to the lead-frame 12, one or more of the three slots 16, 18, 20 is cut through thereby segmenting the main body portion of the lead-frame 12 into electrically isolated sections as desired and providing desired electrical connection between connectors 24, 26 and the ASIC 30. If all three slots are cut through, areas 15, 17, 19, and 21 will be electrically isolated from each other. If only slot 14 is cut through, area 15 will be electrically isolated from areas 17, 19, 21 with areas 17, 19, 21 remaining electrically connected together. As should be appreciated, prior to the attachment of the ASIC 30 to the lead-frame 12 and any of the slots cut through, all areas 15, 17, 19, and 21 of the main body portion 28 were electrically linked or connected together. The attached ASIC 30 mechanically holds the main body portion 28 of the lead-frame 12 together after the selected slots are cut through. Cutting through of selected slots achieves a desired electrical connection between the connectors 24, 26 and the ASIC 30.

In accordance with one example embodiment of the present invention, the center slot 18 is cut through thereby segmenting the main body portion 28 of the lead-frame 12 into two pieces that are electrically isolated from each other. In effect, areas 15 and 17 are still electrically connected together and areas 19 and 21 are still electrically connected together but areas 15, 17 are electrically isolated from areas 19, 21. This then allows for separate electrical connection to internal circuitry of the ASIC 30 via the connectors 24, 26 to particular circuitry within the ASIC 30. After the ASIC 30 is attached to the main body portion 28 of the lead-frame 12 and the slot 18 is cut through, the ASIC 30 and a portion of the lead-frame 12 is overmolded with an appropriate soft material 40 so as to completely surround the ASIC 30 to protect it from moisture exposure.

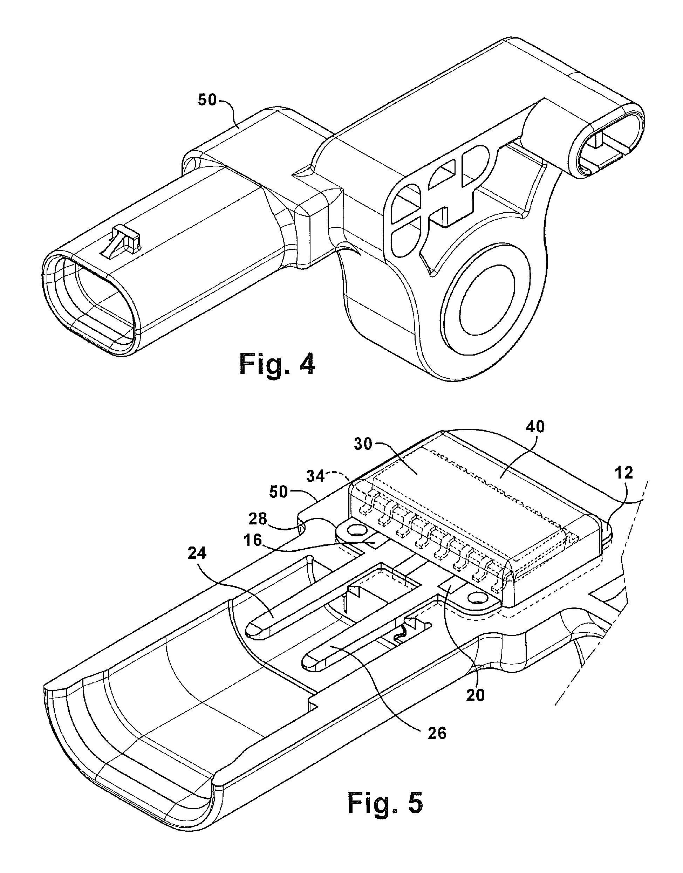

Referring to Figs. 4 and 5, a hard outer shell 50 is molded over the lead-frame 12 in a second process step. The outer shell 50 forms a housing that can then be mechanically attached to a mounting structure within the vehicle. As mentioned, the ASIC 30 is fully surrounded by the soft material 40. The hard outer shell 50 is then overmolded over the first softer layer so as to bond to the inner soft material to provide mechanical protection for the ASIC 30 and also to transmit a crash impact pulse to the lead-frame 12 because of the direct contact between the harder outer layer 50 and the lead-frame 12. The hard outer shell forms a continuous seamless molded structure around the lead-frame 12 that permits transmission of any crash impulse acceleration force from the vehicle body to the accelerometer within the ASIC. Also, if the ASIC 30 includes a pressure sensor, an access port is provided through both the soft material and the hard outer material so as to allow air pressure to access the sensor within the ASIC.

The soft first layer that is molded over the ASIC is, in accordance with one example embodiment of the present invention, a rubber/plastic elastomeric polymer (such as TPE (thermoplastic elastomer)) material. The hard outer plastic body that forms the housing 50 is glass filled nylon but could be made from other plastics such as polypro or PBT. The hard outer layer is bonded to the soft inner layer through an injection overmolding process. Bonding and adhesion between the two layer materials (soft inner layer and the hard outer layer) is an important factor in material selection. The main body portion 28 could include a plurality of openings or holes 54 that aid in bonding the molding materials to the lead-frame 12 and provide a more secure mechanical connection therebetween.

A process in accordance with one example embodiment of the present invention for assembling a circuit includes the steps of mounting an integrated circuit to a segmented lead frame having a severable slots and a plurality of connectors, securing the integrated circuit to the segmented lead frame, and severing the slots completely through so as to provide a desired electrical connection between the connectors and the integrated circuit.

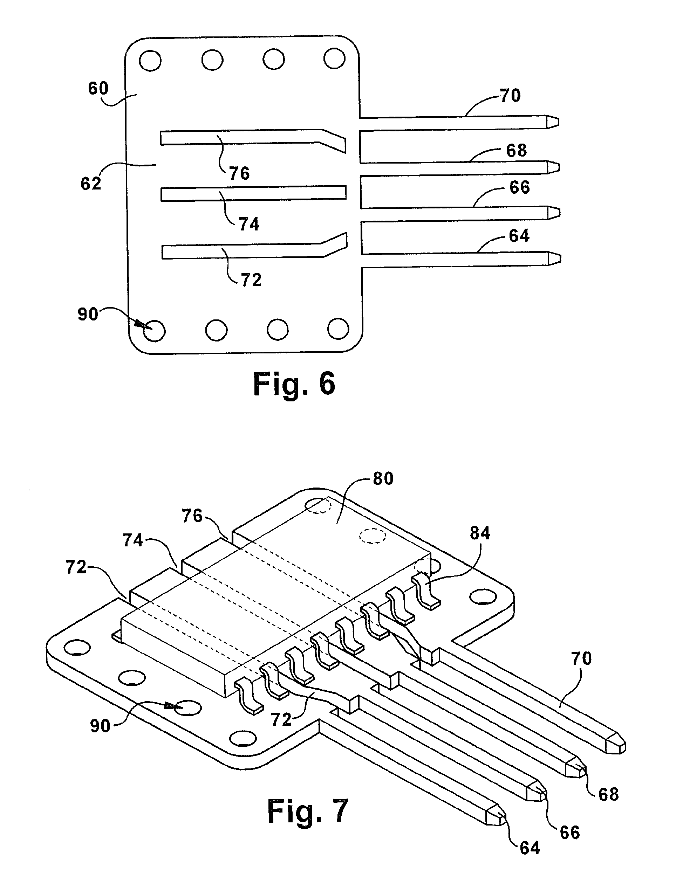

Referring to Figs. 6 and 7, another example embodiment of a segmented lead-frame 60 is shown having a main segmented body portion 62 and a plurality of electrical connectors 64, 66, 68, 70 extending from the main body portion 62. The main body portion 62 includes a plurality of slots 72, 74, 76.

An ASIC 80 includes a plurality of electrical leads 84 that provide both mechanical and electrical connection between the ASIC 80 and the lead-frame 60. The ASIC 80 is welded or soldered to the lead-frame 60 in a similar manner as described above. After attachment of the ASIC 80 to the lead frame, selected severable slots 72, 74, 76 are cut through to make a desired electrical connection between the connectors 64, 66, 68, 70 and the ASIC 80. After appropriate electrical segmentation is completed, the circuit assembly is overmolded as described above with two layers. If all three severable slots 72, 74, 76 are cut through, the main body portion will be divided into four electrically isolated segments for separate electrical connection between the connectors 64, 66, 68, 70 and the ASIC 80.

As should be appreciated, the circuit assembly in accordance with the present invention provides connection between an ASIC and outside control circuitry without need for a PCB. The segmented lead-frame of the present invention provides segmentation into two or more areas depending on the number of severable slots to achieve a desired electrical connection configuration. As mentioned, the lead-frame coupon could be provided individually or in a strip of coupons that is later separated. The severable slots are cut through after the ASIC is mounted so as to achieve desired electrical functionality. The attachment of the ASIC maintains lead-frame stability after the selected slots are cut through. The uncut slots provide stability for attachment of the ASIC and then the ASIC provides stability after the slots are cut. As should be appreciated, the severable slots provides for a customized interconnection between the lead-frame connectors and the ASIC. The number, size, and shape of the severable connection links can be as desired to achieve the desired electrical functionality. Also, it should be appreciated that one lead-frame with a plurality of slots can be used with different ASIC's where each of the different ASIC's require different slots to be cut through to achieve the desired electrical connection.

From the above description of the invention, those skilled in the art will perceive improvements, changes and modifications. Such improvements, changes and modifications within the skill of the art are intended to be covered by the appended claims.

## Claims

1. A circuit mounting assembly comprising:
a segmented lead frame; and
an integrated circuit mounted on the segmented lead frame;
said segmented lead frame having a main body portion with at least one severable slot and a plurality of connectors extending from the main body portion, electrical communication between the plurality of connectors and the integrated circuit being controlled by severance of said at least one slot.

2. The circuit mounting assembly of claim 1 further comprising:
a first insert molded soft inner layer of material partially covering the segmented lead frame and covering the integrated circuit; and
a second overmolded hard outer layer of material covering the first soft inner layer of material and bonded thereto and rigidly contacting the segmented lead frame.

3. The circuit mounting assembly of claim 1 wherein said integrated circuit is an application specific integrated circuit.

4. The circuit mounting assembly of claim 3 wherein said integrated circuit includes sensors for sensing a vehicle crash event.

5. A method for assembling a circuit comprising the steps of:
mounting an integrated circuit to a segmented lead frame having at least one severable slot and a plurality of connectors;
securing the integrated circuit to the segmented lead frame; and
severing the at least one severable slot so as to provide a desired electrical connection between the connectors and the integrated circuit.

6. The method of claim 5 further comprising the steps of:
insert molding a soft inner layer of material over a portion of the segmented lead frame and covering the integrated circuit; and
overmolding a hard outer layer of material over the first soft inner layer of material and contacting the segmented lead frame.
